Europäisches Patentamt

European Patent Office

Office européen des brevets

(11) Veröffentlichungsnummer: **0 005 460**
**A1**

(19)
(12)

# EUROPÄISCHE PATENTANMELDUNG

(21) Anmeldenummer: 79101239.6

(22) Anmeldetag: 24.04.79

(51) Int. Cl.²: **B 23 K 26/00**
**H 01 J 37/30**

(30) Priorität: 19.05.78 DE 2821883

(43) Veröffentlichungstag der Anmeldung:
28.11.79 Patentblatt 79/24

(84) Benannte Vertragsstaaten:
DE FR GB

(71) Anmelder: International Business Machines
Corporation

Armonk, N.Y. 10504(US)

(72) Erfinder: Makosch, Günter
Stuttgarter Strasse 40
D-7032 Sindelfingen-Maichingen(DE)

(72) Erfinder: Schedewie, Franz, Dr.
Schurwaldstrasse 18
D-7030 Böblingen(DE)

(72) Erfinder: Schmackpfeffer, Arno, Dr.
Bergamastrasse 29
D-7030 Böblingen(DE)

(72) Erfinder: Ziller, Jörg
Brucknerstrasse 20
D-7032 Sindelfingen(DE)

(74) Vertreter: Teufel, Fritz, Dipl.-Phys.
Schönaicher Strasse 220
D-7030 Böblingen(DE)

(54) Vorrichtung zur Materialbearbeitung.

(57) Beim Schweißen und Bohren mit Laserstrahlen ist die Wärmeabfuhr im Werkstück in radialer Richtung im Randbereich des Strahls wesentlich besser als in der Mitte, so daß selbst bei einer homogenen Engergieverteilung über den ganzen Strahlquerschnitt die Werkstücktemperatur im Mittelbereich des Strahlquerschnitts unter Umständen wesentlich höher ist als im Randbereich. Da praktisch alle Laser- und Korpuskolarstrahlen eine Gauß'sche Intensitätsverteilung haben, liegen die Verhältnisse in der Praxis noch wesentlich ungünstiger.

Daher wird gemäß der Erfindung ein Laserstrahl (2) auf die Grundfläche eines aus durchsichtigem, brechenden Material bestehenden, auch als Axikon bekannten Konus (5) gerichtet. Beim Austritt wird der Strahl so gebeugt, daß eine divergierende Intensitätsverteilung in Form eines Hohlkonus entsteht. Durch eine nachgeschaltete Linse (6), die in Bezug auf das Axikon oder auf ein Werkstück (7) axial verschiebbar ist, können auf letzterem ring- oder topfförmige Temperaturverteilungen erzeugt werden, die eine Homogenisierung der Temperatur im Werkstück bewirken.

FIG. 1

- 1 -

## Vorrichtung zur Materialbearbeitung

Die Erfindung betrifft eine Vorrichtung zur Materialbearbeitung mit Hilfe von Laser- oder Korpuskularstrahlen, insbesondere zum Bohren, Schweißen oder Stanzen.

Auf vielen Gebieten der Technik, insbesondere auf dem Gebiete der Feinwerktechnik, gewinnt die Verwendung von Laser- und Elektronenstrahlen zum Bohren, Schweißen oder Stanzen immer mehr an Bedeutung. Es hat sich dabei gezeigt, daß die Intensität der dabei den Werkstücken zugeführten Strahlenenergie sehr genau dosiert werden muß, da, insbesondere bei der Bearbeitung von sehr kleinen oder dünnen Werkstücken, zum Teil ganz erhebliche Störungen auftreten können. So treten beispielsweise beim Punktschweißen sehr dünner Bleche anstelle oder innerhalb der Schweißverbindungen Löcher auf, wenn die erforderliche Energie der verwendeten Strahlen nur geringfügig überschritten wird, während bei zu kleinen Strahlenergien unzureichende Schweißverbindungen entstehen.

Aber auch beim Bohren und Stanzen mit Laser- und Elektronenstrahlen müssen die zur einwandfreien Durchführung des Verfahrens ermittelten Strahlenenergien sehr genau eingehalten werden, damit Löcher mit den gewünschten Durchmessern und der erforderlichen Beschaffenheit der Lochwände erhalten werden. Ist nämlich die Energie des verwendeten Strahles zu niedrig dauert der Bohrvorgang zu lange oder die Bohrlöcher weisen nicht die gewünschte Form auf, so daß ein wirtschaftliches Arbeiten nicht möglich ist. Ist die Strahlenenergie dagegen zu groß, so gehen die zu entfernenden Bereiche nicht, wie zur Herstellung einwandfreier Bohrlöcher erforderlich, in den flüssigen, sondern unter Umständen explosionsartig unmittelbar in den gasförmigen Zustand über, was zu Beschädigungen der Bohrlochwände oder zu Verschmutzungen der Umgebung der Bohrlöcher durch das ausgeworfene Material führen kann.

GE 978 004 E

- 2 -

Da die Energieverteilung in praktisch allen Laser- und Elektronenstrahlen gemäß einer Gauß-Kurve verläuft, leuchtet es ein, daß es in der Regel nicht möglich sein wird, die optimale Energiedichte über dem ganzen Strahlquerschnitt einzustellen, was dazu führt, daß die theoretisch mögliche hohe Qualität der Bohrlöcher und der Schweißverbindungen praktisch nie erreicht werden kann. Zieht man noch in Betracht, daß die Wärmeabfuhr in radialer Richtung im Zentrum eines Bohrloches oder einer Schweißstelle am schlechtesten und im Randbereich am besten ist, kann leicht eingesehen werden, daß die in fast allen Fällen auftretenden Temperaturverteilungen im Werkstück noch ungünstiger als die Energiedichteverteilung in allen bisher bekannten Bearbeitungsstrahlen ist. Die durch die oben beschriebenen Tatbestände bedingten Nachteile können nur in beschränktem Umfang durch technisch umständliche und zeitraubende Maßnahmen, wie insbesondere Maßnahmen zur Wärmeabfuhr und Verwendung von Impulslasern vermieden werden. In der deutschen Offenlegungsschrift 24 46 962 ist zwar schon vorgeschlagen worden, durch im zentralen Bereiche des Laserstrahls angeordnete Blenden ringförmige Energieverteilungen zu erzeugen, durch die ein Teil der oben genannten Nachteile behoben werden kann. Abgesehen von der hohen Energiebelastung dieser Blenden und der Schwierigkeit ihrer Justierung können mit diesen Vorrichtungen nur bestimmte, einen Grenzwert darstellende Energieverteilungen erzeugt werden, die für viele Anwendungen unzureichend oder zumindest nicht optimal sind. Es ist auch schon vorgeschlagen worden, siehe beispielsweise die Veröffentlichung: "Kontaktieren von Halbleiterbauelementen mit Laserstrahlen mit nicht-gaußförmiger Intensitätsverteilung" von K.H. Drake et al, DVS-Berichte 40 (1976), Löten und Schweißen in der Elektronik, Werner-Verlag GmbH, Düsseldorf, durch besondere Maßnahmen im Laserresonator, beispielsweise durch Verwendung von Modenblenden, Energiedichteverteilungen mit sogenannten Topfkuchenprofilen zu erzeugen, die eine

GE 976 004 E

- 3 -

günstige Wärmeverteilung in den zu bearbeitenden Werkstücken ermöglichen. Der erforderliche technische Aufwand ist aber so groß und die Verwendung einer bestimmten Apparatur auf einen so engen Bereich von Materialeigenschaften, Materialdicken und Bohrloch- bzw. Schweißstellendurchmessern begrenzt, daß die Anwendung derartiger Vorrichtungen nur in wenigen Fällen möglich ist.

Die Erfindung geht von der Aufgabe aus, eine Vorrichtung anzugeben, mit der in einfacher Weise und ohne Lichtverluste für den jeweiligen Zweck und bei Vorliegen unterschiedlichster Randbedingungen optimale Temperaturverteilungen eingestellt werden können. Diese Aufgabe wird durch die im Anspruch 1 beschriebene Erfindung gelöst.

Bei den bisher bekannten Vorrichtungen der oben genannten Art, mußte zur Durchführung von Bohr- oder Schweißarbeiten für jedes Material, für jede Werkstückdicke sowie für jede Bohrloch- oder Schweißstellengröße in der Regel eine auf die jeweils vorliegenden Randbedingungen und Anforderungen abgestimmte Vorrichtung ausgewählt, in vielen Fällen sogar besonders hergestellt werden. Trotzdem konnten die für jeden besonderen Fall optimalen Temperaturverteilungen stets nur angenähert, in den meisten Fällen nur grob angenähert erreicht werden. Außer einem verhältnismäßig hohen apparativen und zeitlichen Aufwand wurden an das Bedienungspersonal, insbesondere bei einem Übergang zu neuen Anwendungsgebieten, sehr hohe Anforderungen gestellt. Darüber hinaus war die Qualität der erzielten Ergebnisse in der Regel wesentlich schlechter als dies bei Vorliegen einer idealen Temperaturverteilung im Werkstück an sich möglich gewesen wäre. Mit der vorliegenden Erfindung ist es dagegen möglich, die für die jeweils zu bearbeitenden Materialien, Werkstückdicken, Bohrloch- oder Schweißstellendurchmesser usw. erforderlichen Energieverteilungen in einfacher Weise, beispielsweise durch

GE 978 004 E

- 4 -

axiale Verschiebung eines oder mehrerer optischer Elemente im Strahlengang optimal einzustellen. Durch Anbringung geeigneter Skalen an den zu verschiebenden Elementen kann die erfindungsgemäße Vorrichtung selbst von Hilfskräften auf Arbeiten unter verschiedenartigsten Randbedingungen eingestellt werden, während· es mit den bisher bekannten Vorrichtungen der oben angegebenen Art erforderlich war, beim Übergang von einer Arbeitsweise zur anderen oder bei einer wesentlichen Änderung der Randbedingungen umfangreiche Umbauten und komplizierte Neueinstellungen vorzunehmen.

Die Erfindung wird anschließend anhand der Figuren näher erläutert.

Es zeigen:

Fig. 1     die schematische Darstellung eines Ausführungsbeispiels der Erfindung,

Fig. 2     die schematische Darstellung des Temperaturverlaufs in einem Werkstück, das von einem eine gauß'sche Energieverteilung aufweisenden Laserstrahl beaufschlagt wird,

Fig. 3     die schematische Darstellung des Temperaturverlaufs in einem Werkstück bei der Bearbeitung mit dem in Fig. 1 dargestellten Ausführungsbeispiel,

Fig. 4     die schematische Darstellung des Strahlenverlaufs bei dem in Fig. 1 dargestellten Ausführungsbeispiel und die in verschiedenen Ebenen auftretenden Energieverteilungen im Laserstrahl.

GE 978 004E

- 5 -

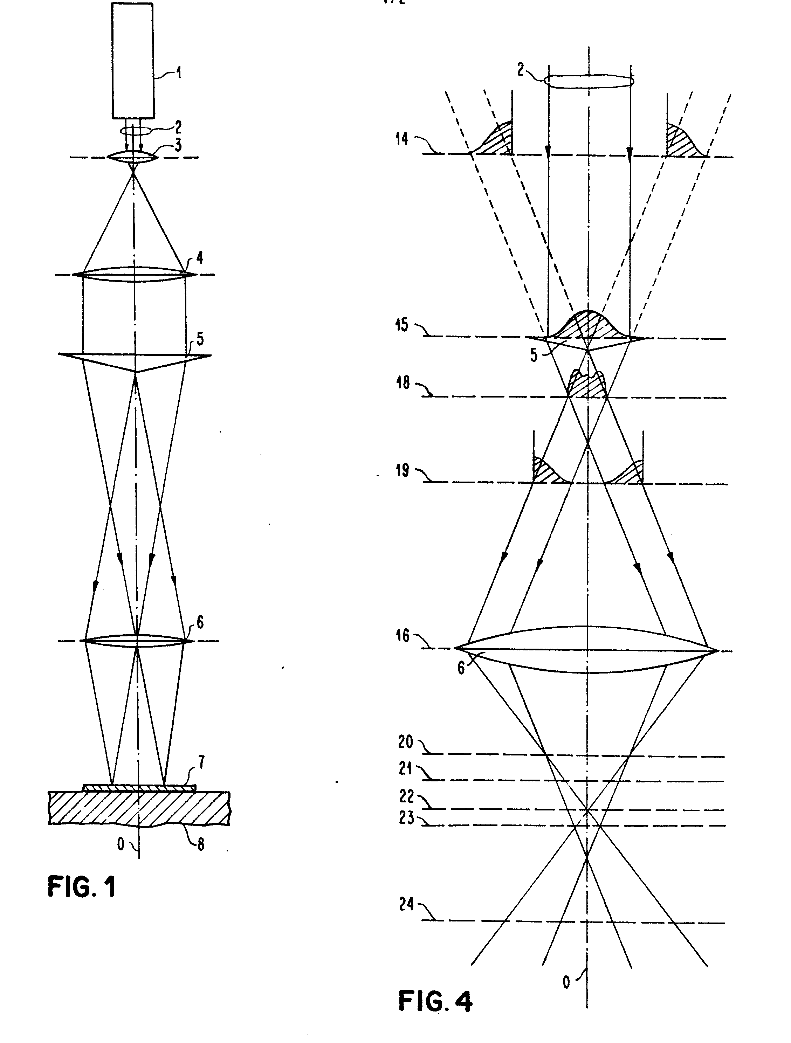

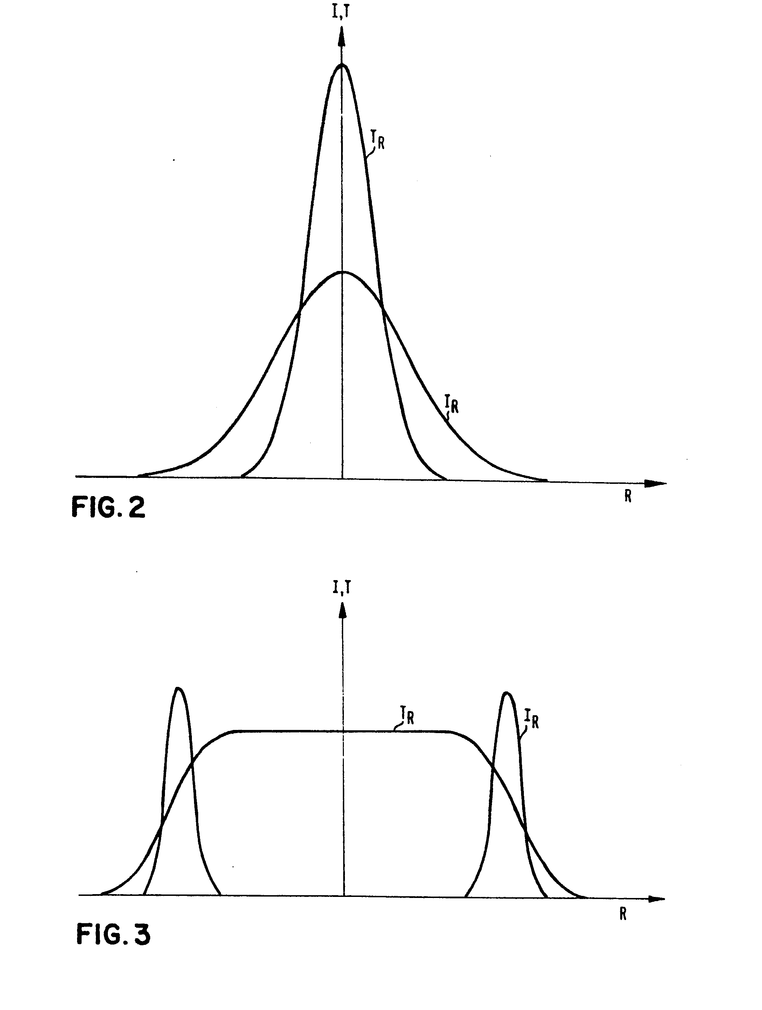

Das in Fig. 1 dargestellte Ausführungsbeispiel besteht aus einer als Laser ausgebildeten Lichtquelle 1, Linsen 3 und 4 zur Aufweitung des Strahlquerschnittes, einem aus durchsichtigem brechenden Material, beispielsweise aus Glas oder Quarz bestehenden rotationssymmetrischen Konus 5 (Axikon) und einer Linse 6 zur Fokussierung der durch den Konus 5 bewirkten Energieverteilung auf die Oberfläche eines zu bearbeitenden Werkstücks 7, das auf einem Kreuzsupport 8 angeordnet ist. Der Querschnitt des vom Laser ausgehenden Strahles 2 wird in der aus den Linsen 3 und 4 bestehenden Vorrichtung aufgeweitet. Der Strahl fällt anschließend auf die Rückseite des rotationssymmetrischen Konus 5. Beim Austritt aus der rückwärtigen Fläche des Konus wird der Strahl so gebeugt, daß ein Hohlkonus entsteht, dessen Wanddicke gleich dem halben Durchmesser des in den Konus 5 eintretenden Strahles ist. Eine Schnittansicht dieses Hohlkonuses ist im Mittelteil der Fig. 4 dargestellt. Der Intensitätsverlauf des auf der Oberfläche des Werkstücks 7 entstehenden ringförmigen Strahlungsbereiches ist in Fig. 3 mit $I_R$ bezeichnet. Wird ein diese Energieverteilung aufweisender Strahl auf ein Werkstück gerichtet, so entsteht wegen der guten Wärmeableitung in den Randbereichen in radialer Richtung und des Wärmestaus im mittleren Bereich die durch die Kurve $T_R$ dargestellte Temepraturverteilung. Wird ein Werkstück jedoch durch einen, die übliche Gauß'sche Energieverteilung aufweisenden Laserstrahl beaufschlagt, so entsteht wegen der guten Wärmeabfuhr in den Randbereichen in radialer Richtung und des im Mittelbereich auftretenden Wärmestaus eine Temperaturverteilung entsprechend einer wesentlich steileren Gauß-Kurve. In Fig. 2 stellt die mit $I_R$ bezeichnete Kurve die übliche Energieverteilung eines Laserstrahls als Funktion der Entfernung von der Mittelachse des Strahls und die mit $T_R$ bezeichnete Kurve die Wärmeverteilung dar. Es ist ohne weiteres einleuchtend, daß bei dem in Fig. 2 dargestellten Verlauf der Wärmeverteilung nur nahezu punktförmige Schweißverbindungen und nur unter Einhaltung genauer

GE 978 004E

- 6 -

Randbedingungen annähernd zylinderförmige Löcher hergestellt werden können. Dagegen können mit dem in Fig. 3 dargestellten und mit $T_R$ bezeichneten Verlauf der Wärmeverteilung relativ großflächige Schweißverbindungen hergestellt werden, ohne daß an die genaue Einhaltung der durch den Laserstrahl zugeführten Energie besonders hohe Anforderungen gestellt werden müssen.

In den Ebenen 15, 18 und 19 entstehen die durch die schraffierten Bereiche dargestellten Energieverteilungen. In den Ebenen 22, 23 und 24 treten die den Energieverteilungen in den Ebenen 15, 18 und 19 zugeordneten Energieverteilungen in verkleinertem Maßstab auf. Die in der Ebene 14 dargestellte Energieverteilung dient zur Konstruktion der in der Ebene 21 auftretenden Energieverteilung. Die in Fig. 1 auf der Oberfläche des Werkstücks 7 auftretende Energieverteilung ist bei dem in Fig. 4 wiedergegebenen Strahlenverlauf in der Ebene 20 dargestellt.

Es ist ohne weiteres ersichtlich, daß durch Verschiebung des Werkstückes in Richtung der optischen Achse 0 die Energieverteilung des Laserstrahls in weiten Grenzen verändert werden kann. Zusätzliche Variationsmöglichkeiten ergeben sich aus einer Relativverschiebung zwischen dem Konus 5 und der Linse 6.

- 7 -

<u>P A T E N T A N S P R Ü C H E</u>

1. Vorrichtung zur Materialbearbeitung wie Bohren, Stanzen und Schweißen mit Hilfe von Laser- oder Korpuskularstrahlen, gekennzeichnet durch ein im Verlauf des Bearbeitungsstrahls angeordnetes dioptrisches oder katoptrisches Element (5) zur achsensymmetrischen Inversion der achsennahen und der achsenfernen Querschnittsbereiche des Bearbeitungsstrahls und ein in Strahlenfortpflanzungsrichtung dahinter angeordnetes fokussierendes Element.

2. Vorrichtung nach Anspruch 1, dadurch gekennzeichnet, daß das invertierende Element (5) als ein aus durchsichtigem brechendem Material bestehender Konus (Axikon) ausgebildet ist.

3. Vorrichtung nach Anspruch 1, dadurch gekennzeichnet, daß das invertierende Element als elektronenoptisches Bauteil ausgebildet ist.

4. Vorrichtung nach einem oder mehreren der Ansprüche 1 bis 3, dadurch gekennzeichnet, daß das invertierende Element (5) und/oder das fokussierende Element (6) zwecks Einstellung der jeweils gewünschten Energiedichteverteilung und des Strahldurchmessers in Richtung der optischen Achse gemeinsam und/oder relativ zueinander verschiebbar angeordnet sind.

5. Vorrichtung nach Anspruch 4, dadurch gekennzeichnet, daß das invertierende Element (5) und/oder das fokussierende Element (6) mit dem Durchmesser und die Energiedichteverteilung des erzeugten Bearbeitungsstrahls anzeigenden Skalen versehen sind.

6. Vorrichtung nach einem oder mehreren der Ansprüche 1 bis 5, dadurch gekennzeichnet, daß die Lichtquelle (11) als Laser ausgebildet ist.

7.  Vorrichtung nach Anspruch 5, gekennzeichnet durch eine
    in Fortpflanzungsrichtung vor dem invertierenden Element
    (5) angeordnete Vorrichtung (3, 4) zur Strahlaufweitung.

FIG. 1

FIG. 4

I,T

$T_R$

$I_R$

R

**FIG. 2**

I,T

$T_R$

$I_R$

R

**FIG. 3**

![Europäisches Patentamt] **Europäisches Patentamt**    **EUROPÄISCHER RECHERCHENBERICHT**    Nummer der Anmeldung

**EP 79 10 1239**

## EINSCHLÄGIGE DOKUMENTE

| Kategorie | Kennzeichnung des Dokuments mit Angabe, soweit erforderlich, der maßgeblichen Teile | betrifft Anspruch |
|---|---|---|
| X | US - A - 3 419 321 (R.B. BARBER et al.)<br><br>* Spalten 2,3; Abbildungen 1-3 *<br><br>-- | 1,2,4-7 |
| | IBM JOURNAL OF RESEARCH AND DEVELOPMENT, Vol. 21, Nr. 6, November 1977,<br>New York, USA,<br>J.L. MAUER: "Electron optics of an electron-beam lithographic system", Seiten 514-521<br><br>* Seiten 514-516; Abbildungen 1-3 *<br><br>---- | 1,3 |

**KLASSIFIKATION DER ANMELDUNG (Int.Cl.²)**

B 23 K 26/00
H 01 J 37/30

**RECHERCHIERTE SACHGEBIETE (Int. Cl.²)**

B 23 K 26/00
H 01 J 37/30

**KATEGORIE DER GENANNTEN DOKUMENTE**

X: von besonderer Bedeutung

A: technologischer Hintergrund

O: nichtschriftliche Offenbarung

P: Zwischenliteratur

T: der Erfindung zugrunde liegende Theorien oder Grundsätze

E: kollidierende Anmeldung

D: in der Anmeldung angeführtes Dokument

L: aus andern Gründen angeführtes Dokument

&: Mitglied der gleichen Patentfamilie, übereinstimmendes Dokument

Der vorliegende Recherchenbericht wurde für alle Patentansprüche erstellt.

| Recherchenort | Abschlußdatum der Recherche | Prüfer |
|---|---|---|
| Den Haag | 04-07-1979 | MALIC |

EPA form 1503.1   06.78